# EUROPÄISCHE PATENTANMELDUNG

(11) **EP 0 612 145 A1**
(43) Veröffentlichungstag der Anmeldung: **24.08.1994**
(21) Anmeldenummer: 94101401.1
(22) Anmeldetag: 31.01.1994
(51) Int. Cl.: H03G 7/00

(54) **Kaskadierbare Schaltungsanordnung zur Signalbegrenzung und Feldstärkedetektion**

(30) Priorität: 18.02.1993 DE 4305039
(71) Anmelder: SIEMENS AKTIENGESELLSCHAFT, D-80333 München (DE)
(72) Erfinder: Thomas, Volker, Dipl.-Ing., D-80798 München (DE); Fenk, Josef, Dipl.-Ing., D-85386 Eching (DE)

(57) **Zusammenfassung**

Kaskadierbare Schaltungsanordnung mit einer Begrenzerverstärkerstufe, die zwei aus einer gemeinsamen ersten Stromquelle (3) gespeiste, emittergekoppelte, jeweils mit einer Last (5, 6) abgeschlossene und durch zueinander inverse Eingangssignale (12, 13) angesteuerte erste Transistoren (1, 2) aufweist, und mit einer Feldstärkedetektorstufe, die zwei aus einer zweiten Stromquelle (23) gespeiste, emittergekoppelte, jeweils durch den Eingangskreis eines Stromspiegels (27 bis 30; 31 bis 34) geschlossene zweite Transistoren (21, 22) aufweist, wobei die Basis eines der beiden zweiten Transistoren (21) mit den gekoppelten Emittern der ersten Transistoren (1, 2) verbunden ist, an die Basis des anderen Transistors (22) ein Referenzpotential (26) angelegt ist und der Ausgangskreis eines der beiden Stromspiegel (27 bis 30) dem Eingangskreis des anderen, das Ausgangssignal führenden Stromspiegels (31 bis 34) parallel geschaltet ist. Dabei sind erste und zweite Transistoren (1, 2; 21, 22) von gegensätzlichem Leitungstyp und der Eingangskreis des das Ausgangssignal führenden Stromspiegels (31 bis 34) schließt denjenigen der zweiten Transistoren (22) ab, an dessen Basis das Referenzpotential (26) angelegt ist.

## Beschreibung

Die Erfindung betrifft eine kaskadierbare Schaltungsanordnung zur Signalbegrenzung und Feldstärkedetektion mit einer Begrenzerverstärkerstufe, die zwei aus einer gemeinsamen ersten Stromquelle gespeiste, emittergekoppelte, jeweils mit einer Last abgeschlossene und durch zueinander inverse Eingangssignale angesteuerte erste Transistoren aufweist, und mit einer Feldstärkedetektorstufe, die zwei aus einer zweiten Stromquelle gespeiste, emittergekoppelte, jeweils durch den Eingangskreis eines Stromspiegels abgeschlossene zweite Transistoren aufweist, wobei die Basis eines der beiden zweiten Transistoren mit den gekoppelten Emittern der ersten Transistoren verbunden ist, an die Basis des anderen Transistors ein Referenzpotential angelegt ist und der Ausgangskreis eines der beiden Stromspiegel dem Eingangskreis des anderen, das Ausgangssignal fuhrenden Stromspiegels parallel geschaltet ist.

Eine derartige Schaltungsanordnung ist beispielsweise bei J. Fenk, B. Birth, R.G. Ervine, P. Sehrig, K.R. Schön "An RF Front-End for Digital Mobile Radio", IEEE 1990, Bipolar Circuits and Technology Meeting 11.2, beschrieben. Durch Kaskadierung mehrerer - in diesem Fall von sieben - einzelner derartiger Schaltungsanordnungen wird eine Empfangsschaltung realisiert, wie sie in der Rundfunk- und Fernsehtechnik sowie der Mobilfunktechnik häufig benötigt wird. Dazu werden die Begrenzerverstärkerstufen hintereinander geschaltet, während die den einzelnen Begrenzerverstärkerstufen jeweils zugeordneten Feldstärkedetektorstufen ausgangsseitig parallel geschaltet werden.

Bei drahtlosen Geräten wird nun im allgemeinen eine lange Batterielebensdauer angestrebt. Außerdem sollen die Batterien geringes Gewicht und kleine äußere Abmessungen aufweisen, um eine kompakte Bauform der Geräte zu gewährleisten. Dazu ist es notwendig, zum einen den Leistungsverbrauch zu verringern und/oder zum anderen die Anzahl der einzelnen Batteriezellen zu minimieren, was eine kleinere Mindestversorgungsspannung der Empfangsschaltungen fordert.

Aufgabe der Erfindung ist es daher, die bekannte Schaltungsanordnung zur Signalbegrenzung und Feldstärkedetektion derart weiterzubilden, daß eine geringere Mindestversorgungsspannung erforderlich ist.

Diese Aufgabe wird bei einer Schaltungsanordnung der eingangs genannten Art dadurch gelost, daß erste und zweite Transistoren von gegensätzlichem Leitungstyp sind und daß der Eingangskreis des das Ausgangssignal fuhrenden Stromspiegels denjenigen der zweiten Transistoren abschließt, an dessen Basis das Referenzpotential angelegt ist.

Durch Verringerung der Anzahl der im Signalweg seriell wirkenden Diodenschwellen in der Feldstärkedetektorstufe wird die erforderliche Mindestversorgungsspannung der gesamten Schaltungsanordnung herabgesetzt. Dadurch wird auch der Betrieb der Begrenzerverstärkerstufe mit einer geringeren Versorgungsspannung ermöglicht. Dies hat wiederum zur Folge, daß die Leistungsaufnahme insgesamt gesenkt und die Anzahl von benötigten Batteriezellen herabgesetzt wird, so daß sich insgesamt Größe und Gewicht der Batterien verringern.

Eine Weiterbildung der Erfindung sieht vor, der Begrenzerverstärkerstufe die Eingangssignale über zwei speziell ausgebildete Emitterfolgerstufen zuzuführen, deren Ausgangsporential jeweils durch Vorschalten der Kollektor-Emitterstrecke eines weiteren Transistors in die Emitterleitung des Emitterfolgertransistors konstant gehalten wird. Die Basen der beiden zusätzlichen Transistoren sind dabei über jeweils eine Diode in Sperrichtung mit ihren Kollektoren verbunden und zum anderen über jeweils einen Widerstand an ein Biaspotential gelegt. Die Diode in Sperrichtung wird dabei als Kopplungskapazität eingesetzt, die jedoch aufgrund des Betriebes in Sperrichtung die Kollektor-Basis-Spannung der zusätzlichen Transistoren nicht auf die Diodendurchlaßspannung begrenzt.

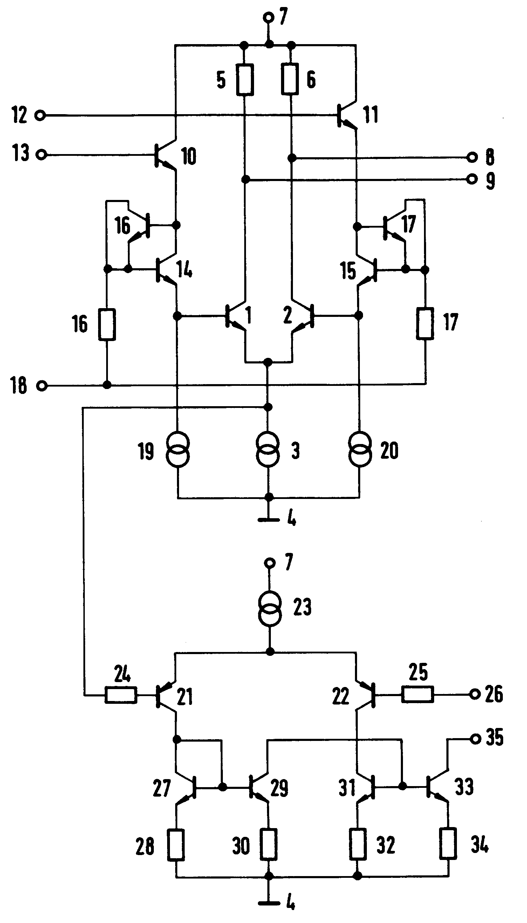

Die Erfindung wird nachfolgend anhand des in der einzigen Figur der Zeichnung dargestellten Ausführungsbeispiels näher erläutert.

Beim gezeigten Ausführungsbeispiel besteht die Begrenzerverstärkerstufe aus zwei npn-Transistoren 1 und 2, deren miteinander gekoppelte Emitter über eine Stromquelle 3 mit einem Bezugspotential 4 verbunden sind. Die Kollektoren der beiden Transistoren 1 und 2 sind über jeweils einen als Last wirkenden Widerstand 5 bzw. 6 an ein Versorgungspotential 7 angeschlossen. Zudem werden an den Kollektoren der beiden Transistoren 1 und 2 differentielle Ausgangssignale 8 und 9 abgenommen.

Den Basen der Transistoren 1 und 2 sind jeweils Emitterfolger vorgeschaltet, die einen npn-Transistor 10 bzw. 11 aufweisen. Die Kollektoren der beiden Transistoren 10 und 11 liegen an dem Versorgungspotential 7, wahrend die Basen dieser beiden Transistoren durch ein differentielles Eingangssignal 12, 13 angesteuert werden. Die Emitter der beiden Transistoren 10 und 11 sind zum einen mit dem Kollektor eines npn-Transistors 14 bzw. 15 direkt und zum anderen mit der Basis eines npn-Transistors 16 bzw. 17 verschaltet. Die Transistoren 16 und 17 werden als Dioden in Sperrichtung betrieben, die zwischen Basis und Kollektor der Transistoren 14 und 15 geschaltet sind. Dazu sind Emitter und Kollektor beim Transistor 16 bzw. 17 miteinander sowie mit der Basis des Transistors 14 bzw. 15 verbunden. Die Basen der Transistoren 14 und 15 sind zudem über jeweils einen Widerstand 16 bzw. 17 an ein Biaspotential 18 gelegt. Schließlich sind die Basen der beiden Transistoren 1 und 2 über je eine Stromquelle 19 bzw. 20 an das Bezugspotential 4 angeschlossen.

Die Transistoren 14 und 15 in Verbindung mit den Sperrschichtkapazitäten der zu Dioden verschalteten Transistoren 16 und 17 bewirken eine kapazitive Einkopplung der Eingangssignale 12 und 13 über die Emitterfolger mit den Transistoren 10 und 11 und den Stromquellen 19 und 20 an die Basen der Transistoren 1 und 2, die zusammen mit den Widerständen 5 und 6 sowie der Stromquelle 3 den eigentlichen Begrenzerverstärker bilden. Die Stromquelle 3 und die beiden Widerstände 5 und 6 sind dabei so bemessen, daß ab einer bestimmten Stärke des Eingangssignals 12, 13 das Ausgangssignal 8, 9 im wesentlichen nicht mehr ansteigt.

Die Feldstärkedetektorstufe enthält erfindungsgemäß zwei Transistoren vom zu den Transistoren 1 und 2 der Begrenzerverstärkerstufe entgegengesetzten Leitungstyp, nämlich die pnp-Transistoren 21 und 22. Deren Emitter sind miteinander gekoppelt und über eine Stromquelle 23 an das Versorgungspotential 7 angeschlossen. Die Basis des Transistors 21 ist über einen Widerstand 24 mit den gekoppelten Emittern der Transistoren 1 und 2 verbunden, während die Basis des Transistors 22 über einen Widerstand 25 an ein Referenzpotential 26 angeschlossen ist. Die Kollektoren der Transistoren 21 und 22 sind über jeweils den Eingangskreis eines Stromspiegels an das Bezugspotential 4 gelegt. Dazu ist der Kollektor des Transistors 21 über einen durch Verbinden von Basis und Kollektor zu einer Diode in Durchlaßrichtung verschalteten npn-Transistor 27 und einen in die Emitterleitung des Transistors 27 geschalteten Widerstand 28 an das Bezugspotential 4 angeschlossen. Basis und Kollektor des Transistors 27 sind mit der Basis eines npn-Transistors 29 verschaltet, dessen Emitter über einen Widerstand 30 ebenfalls mit dem Bezugspotential 4 verbunden ist. Entsprechend ist auch der Kollektor des Transistors 22 über einen durch Verbinden von Basis und Kollektor als Diode in Durchlaßrichtung betriebenen npn-Transistor 31 und einen in die Emitterleitung des Transistors 31 geschalteten Widerstand 32 mit dem Bezugspotential 4 gekoppelt. An Basis und Kollektor des Transistors 31 ist demgemäß die Basis eines npn-Transistors 33 angeschlossen, dessen Emitter über einen Widerstand 34 mit dem Bezugspotential 4 verbunden ist und dessen Kollektor ein Ausgangssignal 35 fuhrt. Zudem ist der Ausgangskreis des Stromspiegels mit den Transistoren 27 und 29 sowie den Widerständen 28 und 29 mit dem Eingangskreis des Stromspiegels mit den Transistoren 31 und 33 sowie den Widerständen 32 und 34 gekoppelt. Dazu ist der Kollektor des Transistors 29 mit den Kollektoren der Transistoren 22 und 31 verbunden.

Die erfindungsgemäße Schaltungsanordnung unterscheidet sich also von der eingangs genannten, bekannten Anordnung dadurch, daß bei Feldstärkedetektorstufe und Begrenzerverstärkerstufe Differenzverstärker mit Transistoren von gegensätzlichem Leitungstyp verwendet werden .Daraus ergibt sich, daß die gekoppelten Emitter der Transistoren 1 und 2 über die gemeinsame Stromquelle 3 auf Bezugspotential 4 gelegt sind, während die gekoppelten Emitter der Transistoren 21 und 22 über die gemeinsame Stromquelle 23 an das Versorgungspotential 7 angeschlossen sind. Folglich sind auch die jeweiligen Lasten mit unterschiedlichen Potentialen verbunden. Es sind demnach die Widerstände 5 und 6 zwischen die Kollektoren der Transistoren 1 und 2 und das Versorgungspotential 7 geschaltet, wahrend die Eingangskreise der beiden Stromspiegel, gebildet durch die Transistoren 27 bzw. 31 und die Widerstände 28 bzw. 32, zwischen die Kollektoren der Transistoren 21 und 22 und das Bezugspotential 4 geschaltet sind. Daraus ergibt sich für die erfindungsgemäße Schaltungsanordnung, daß das Eingangssignal der Feldstärkedetektorstufe, nämlich die Differenz zwischen dem Potential an der Basis des Transistors 21 und dem Bezugspotential, lediglich eine durch den zu einer Diode verschalteten Transistor 27 vorgegebene Diodenschwelle zu überwinden braucht. Bei der bekannten Anordnung dagegen ist die einer Diodenschwelle gleichkommende Basis-Emitter-Spannung des einen Transistors der Differenzverstärkerstufe sowie der Spannungsabfall über der Stromquelle, der immer größer als eine Diodenschwelle ist, zu übersteigen ist. Dabei ist auch von Bedeutung, daß der mit dem Eingangssignal beaufschlagte Transistor 21 nur mit dem Eingangskreis eines Stromspiegels belastet ist, was in etwa einer Diodenschwelle gleichkommt, während der mit dem Referenzpotential 26 angesteuerte Transistor 22 sowohl mit dem Ausgangskreis des einen Stromspiegels als auch mit dem Eingangskreis des anderen Stromspiegels belastet wird, was einen höheren Spannungsabfall an dieser Stelle zur Folge hat. Der Ausgangskreis des anderen Stromspiegels mit dem Transistor 33 und dem Widerstand 34 bildet im Gegensatz zur bekannten Anordnung nun anstelle einer Stromquelle eine Stromsenke. Bei der Kaskadierung können diese Stromsenken jedoch in gleicher Weise parallel geschaltet werden. Mittels eines nachgeschalteten zusätzlichen Stromspiegels läßt sich jedoch auf einfache Weise auch ein Stromquellenbetrieb herstellen.

Durch die Erfindung wird also mit geringstem schaltungstechnischen Aufwand die Mindestversorungsspannung für die Feldstärkedetektorstufe und damit für die gesamte Anordnung herabgesetzt. Indem der Eingangsspannungsbereich der Feldstärkedetektorstufe verkleinert wird, kann auch das an den gekoppelten Emittern der beiden emittergekoppelten Transistoren der Begrenzerverstärkerstufe auftretende Potential herabgesetzt werden, so daß bei gleichen Eingangssignal- und Ausgangssignalbereichen bei der Begrenzerverstärkerstufe das Versorgungspotential insgesamt herabgesetzt werden kann. Durch die demzufolge geringere Versorgungsspannung erniedrigt sich auch der Leistungsverbrauch beider Stufen. Dadurch verringert sich nicht nur die Anzahl der Batteriezellen, sondern auch Größe und Gewicht der Batterien insgesamt, da bei Verringerung der Zellenzahl die restlichen Batterien in ihrer Kapazität nicht vergrößert werden müssen.

## Patentansprüche

1. Kaskadierbare Schaltungsanordnung mit einer Begrenzerverstärkerstufe, die zwei aus einer gemeinsamen ersten Stromquelle (3) gespeiste, emittergekoppelte, jeweils mit einer Last (5, 6) abgeschlossene und durch zueinander inverse Eingangssignale (12, 13) angesteuerte erste Transistoren (1, 2) aufweist, und mit einer Feldstärkedetektorstufe, die zwei aus einer zweiten Stromquelle (23) gespeiste, emittergekoppelte, jeweils durch den Eingangskreis eines Stromspiegels (27 bis 30; 31 bis 34) abgeschlossene zweite Transistoren (21, 22) aufweist, wobei die Basis eines der beiden zweiten Transistoren (21) mit den gekoppelten Emittern der ersten Transistoren (1, 2) verbunden ist, an die Basis des anderen Transistors (22) ein Referenzpotential (26) angelegt ist und der Ausgangskreis eines der beiden Stromspiegel (27 bis 30) dem Eingangskreis des anderen, das Ausgangssignal führenden Stromspiegels (31 bis 34) parallel geschaltet ist,
**dadurch gekennzeichnet,** daß erste und zweite Transistoren (1, 2; 21, 22) von gegensätzlichem Leitungstyp sind und daß der Eingangskreis des das Ausgangssignal führenden Stromspiegels (31 bis 34) denjenigen der zweiten Transistoren (22) abschließt, an dessen Basis das Referenzpotential (26) angelegt ist.

2. Schaltungsanordnung nach Anspruch 1,
**dadurch gekennzeichnet,** daß dritte Transistoren (10, 11) vom gleichen Leitungstyp wie die ersten Transistoren (1, 2) vorgesehen sind, deren Kollektoren mit dem Versorgungspotential (7) verbunden sind und an deren Basen die Eingangssignale (12, 13) angelegt sind, und durch vierte Transistoren (14, 15) vom gleichen Leitungstyp wie die ersten Transistoren (1, 2) deren Kollektoren jeweils mit den Emittern eines der dritten Transistoren (10, 11) und deren Emitter mit den Basen eines der ersten Transistoren (1, 2) direkt sowie über jeweils eine Stromquelle (19, 20) mit einem Bezugspotential (4) verbunden sind.
